# EUROPEAN PATENT APPLICATION

(11) **EP 3 624 143 A1**
(43) Date of publication of application: **18.03.2020**
(21) Application number: 18798094.1
(22) Date of filing: 07.05.2018
(51) Int. Cl.: H01B 12/06, C23C 14/08, H01F 6/06, H01L 39/02, H01L 39/24

(54) **SUPERCONDUCTING WIRE AND SUPERCONDUCTING COIL**

(30) Priority: 12.05.2017 JP 2017095548; 12.05.2017 JP 2017095696
(71) Applicant: Fujikura Ltd., Tokyo 135-8512 (JP)
(72) Inventor: NAKAMURA Naonori, Sakura-shi Chiba 285-8550 (JP)
(74) Representative: Plasseraud IP
(86) International application number: PCT/JP2018/017614
(87) International publication number: WO 2018/207727

(57) **Abstract**

A superconducting wire includes a superconducting laminate in which a superconducting layer formed on a base material with a tape shape via an intermediate layer, and a stabilization layer covering at least a portion of the superconducting laminate, where a residual stress inside the stabilization layer is a tensile stress.

## Description

### TECHNICAL FIELD

The present invention relates to a superconducting wire and a superconducting coil.

The present application claims priority based on Japanese Patent Application No. 2017-095548 and Japanese Patent Application No. 2017-095696 filed on May 12, 2017, the contents of which are incorporated herein by reference.

### BACKGROUND

A superconducting wire (for example, Y-based oxide superconducting wire) is used as a power supply cable, a magnetic coil, and the like because the current loss is low (see, for example, Patent Document 1). The superconducting wire may deteriorate due to peeling stress caused by the difference in thermal contraction rate between an impregnated material and a wire during cooling after coiling. In addition, in the above-mentioned superconducting wire, damage such as peeling may occur at a portion of the layer of a laminated structure in an edge portion by coming into contact with a ridge of a winding frame, a ridge of the delivery (or winding) reel, and the like in the manufacturing process of the coil. Deterioration may progress from the damaged portion.

### PRIOR ART DOCUMENT

### PATENT DOCUMENT

[Patent Document 1] Japanese Unexamined Patent Application, First Publication No. 2010-212134

### DISCLOSURE OF INVENTION

### PROBLEMS TO BE SOLVED BY THE INVENTION

The present invention has been made in view of the above circumstances, and provides a superconducting wire and a superconducting coil which are less likely to deteriorate due to damage such as peeling of a layer.

A first aspect of the present invention is a superconducting wire including a superconducting laminate in which a superconducting layer formed on a base material with a tape shape via an intermediate layer, and a stabilization layer covering at least a portion of the superconducting laminate, where a residual stress inside the stabilization layer is a tensile stress.
A second aspect of the present invention is the superconducting wire according to the first aspect, in which a residual stress in a side surface portion of the stabilization layer covering a side surface of the superconducting laminate is a tensile stress along a thickness direction of the superconducting laminate.
A third aspect of the present invention is the superconducting wire according to the first or second aspect, in which the residual stress is 0.2 MPa or more.
A fourth aspect of the present invention is the optical fiber cutter according to any one of the first to third aspects, in which the stabilization layer is a plating layer.
A fifth aspect of the present invention is superconducting coil including the superconducting wire according to any one of the first to fourth aspects, in which the superconducting wire is laminated in a thickness direction of the superconducting coil, the residual stress inside a side surface portion of the stabilization layer covering a side surface of the superconducting laminate is a tensile stress along a thickness direction of the superconducting laminate, and the residual stress is larger than the maximum applied stress in a radial direction of the superconducting coil.

### EFFECTS OF THE INVENTION

According to the above aspects of the present invention, since the residual stress in the inside of the stabilization layer is a tensile stress, a repulsive force in the opposite direction to the residual stress is generated in the superconducting laminate. Therefore, for example, the peeling stress of the superconducting laminate can be relaxed, and damage such as peeling of the oxide superconducting layer can be avoided.

Further, according to the above aspects of the present invention, the residual stress inside the stabilization layer of the oxide superconducting wire is a tensile stress, and the residual stress is larger than the maximum applied stress in the radial direction of the superconducting coil. Therefore, by the repulsive force in the direction opposite to the residual stress, the peeling stress of the superconducting laminate can be relaxed, and damage such as peeling of the oxide superconducting layer can be avoided.

Thus, deterioration due to damage can be prevented.

### BRIEF DESCRIPTION OF THE DRAWINGS

Fig. 1 is a schematic view showing a structure of an oxide superconducting wire of the present embodiment.
Fig. 2 is a view schematically showing a cross-section of the oxide superconducting wire of Fig. 1.
Fig. 3 is a schematic view showing a superconducting coil provided with the oxide superconducting wire of the present embodiment.

### EMBODIMENTS FOR CARRYING OUT THE INVENTION

Hereinafter, the present application will be described based on preferred embodiments with reference to the drawings.

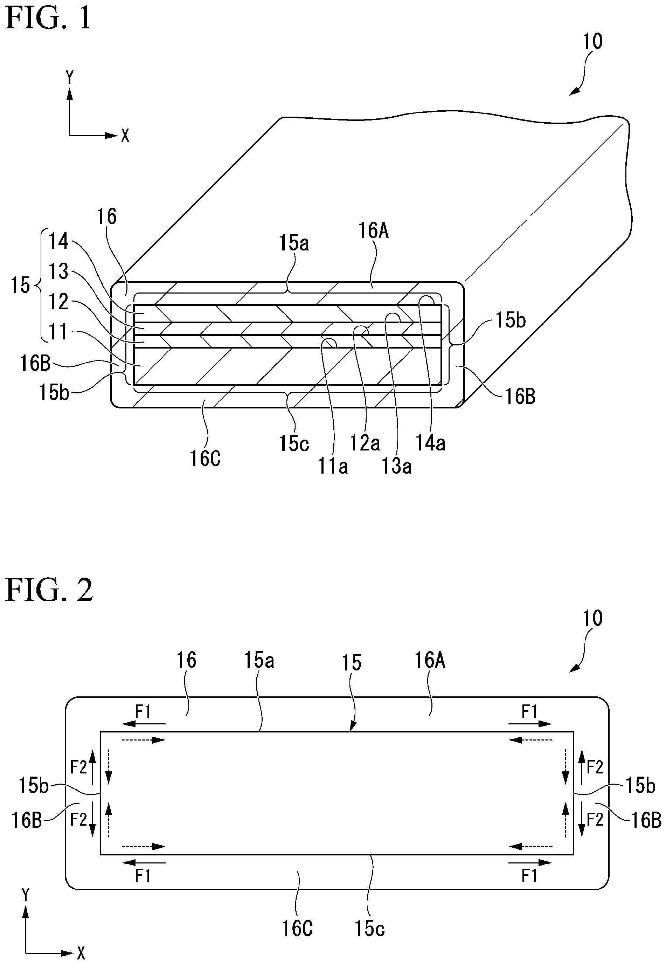

Fig. 1 is a schematic view showing a structure of an oxide superconducting wire (superconducting wire) of the present embodiment. Fig. 1 schematically shows a structure of a cross-section perpendicular to the longitudinal direction of the oxide superconducting wire 10.

As shown in Fig. 1, the oxide superconducting wire 10 of the present embodiment includes a superconducting laminate 15 and a stabilization layer 16.

The superconducting laminate 15 has a structure in which the oxide superconducting layer 13 and the protection layer 14 are formed on the base material 11 via the intermediate layer 12. In particular, the superconducting laminate 15 has a configuration in which the intermediate layer 12, the oxide superconducting layer 13, and the protection layer 14 are laminated in this order on one surface of the tape-shaped base material 11.

Hereinafter, each direction will be described based on the XY coordinate system as needed. The Y direction is the thickness direction of the oxide superconducting wire 10, and is the direction in which the layers such as the base material 11, the intermediate layer 12, the oxide superconducting layer 13, and the protection layer 14 are stacked. The X direction is the width direction of the oxide superconducting wire 10 and is a direction perpendicular to the longitudinal direction and the thickness direction of the oxide superconducting wire 10.

The base material 11 is in the form of a tape, and is formed of, for example, metal. Specific examples of the metal constituting the base material 11 include a nickel alloy represented by Hastelloy (registered trademark); stainless steel; an oriented Ni-W alloy in which a texture is introduced into a nickel alloy, and the like. The thickness of the base material 11 may be appropriately adjusted according to the purpose, and is, for example, in the range of 10 to 500 µm.

The intermediate layer 12 is provided between the base material 11 and the oxide superconducting layer 13. The intermediate layer 12 is formed on one main surface 11a of the base material 11. The intermediate layer 12 may have a multilayer structure, and may have, for example, a diffusion prevention layer, a bed layer, an orientation layer, a cap layer, and the like in order from the base material 11 to the oxide superconducting layer 13. These layers are not necessarily provided one by one, and some layers may be omitted, or two or more layers of the same type may be repeatedly laminated.

The diffusion prevention layer has a function of suppressing a portion of the components of the base material 11 from diffusing and being mixed as an impurity on a side of the oxide superconducting layer 13. The diffusion prevention layer is made of, for example, Si₃N₄, Al₂O₃, GZO (Gd₂Zr₂O₇) or the like. The thickness of the diffusion prevention layer is, for example, 10 to 400 nm.

A bed layer may be formed on the diffusion prevention layer in order to reduce the reaction at the interface between the base material 11 and the oxide superconducting layer 13 and to improve the orientation of the layer formed thereon. Examples of the material of the bed layer include Y₂O₃, Er₂O₃, CeO₂, Dy₂O₃, Eu₂O₃, Ho₂O₃, La₂O₃ and the like. The thickness of the bed layer is, for example, 10 to 100 nm.

The orientation layer is formed of a material that is biaxially oriented to control the crystalline orientation of the overlying cap layer. Examples of the material of the orientation layer include metal oxides such as Gd₂Zr₂O₇, MgO, ZrO₂-Y₂O₃ (YSZ), SrTiO₃, CeO₂, Y₂O₃, Al₂O₃, Gd₂O₃, Zr₂O₃, Ho₂O₃, Nd₂O₃ and the like. The orientation layer is preferably formed by the Ion-Beam-Assisted Deposition (IBAD) method.

The cap layer is formed on the surface of the above-mentioned orientation layer, and made of a material capable of self-orientation of crystal grains in the in-plane direction. Examples of the material of the cap layer include CeO₂, Y₂O₃, Al₂O₃, Gd₂O₃, ZrO₂, YSZ, Ho₂O₃, Nd₂O₃, LaMnO₃ and the like. The thickness of the cap layer may be in a range of 50 to 5000 nm.

The oxide superconducting layer 13 is made of an oxide superconductor. The oxide superconductor is not particularly limited, and examples thereof include a RE-Ba-Cu-O-based oxide superconductor represented by a general formula REBa₂Cu₃OX (RE123). Examples of the rare earth element RE include one or more of Y, La, Ce, Pr, Nd, Sm, Eu, Gd, Tb, Dy, Ho, Er, Tm, Yb, and Lu. Among them, Y, Gd, Eu, Sm, or a combination of two or more of these elements is preferable. In general, X is 7-x (oxygen deficiency x: approximately 0 to 1). The thickness of the oxide superconducting layer 13 is, for example, approximately 0.5 to 5 µm, and is preferably uniform in the longitudinal direction.

The oxide superconducting layer 13 is formed on the main surface 12a (the surface opposite to the side of the base material 11) of the intermediate layer 12.

The protection layer 14 has a function of bypassing an overcurrent generated at the time of an accident or suppressing a chemical reaction occurring between the oxide superconducting layer 13 and a layer provided on the protection layer 14. Examples of the material of the protection layer 14 include silver (Ag), copper (Cu), gold (Au), alloys of gold and silver, other silver alloys, copper alloys, gold alloys and the like. The protection layer 14 covers at least the main surface 13a (the surface opposite to the side of the intermediate layer 12) of the oxide superconducting layer 13.

The protection layer 14 may cover a portion or all of a region selected from the side surface of the oxide superconducting layer 13, the side surface of the intermediate layer 12, and the side surface and the back surface of the base material 11. The protection layer 14 may be composed of two or more kinds of metal layers or a metal layer having two or more layers. The thickness of the protection layer 14 is not particularly limited, and may be, for example, approximately 1 to 30 µm.

The shape of the cross-section perpendicular to the longitudinal direction of the superconducting laminate 15 is rectangular. The superconducting laminate 15 has a rectangular cross-section, i.e., a flat angle cross-section, whose width is larger than its thickness. In Fig. 1, reference numeral 15a denotes a first main surface (the main surface 14a of the protection layer 14: surface opposite to the side of the oxide superconducting layer 13) of the superconducting laminate 15. Reference numeral 15b denotes a side surface of the superconducting laminate 15 (side surface of the base material 11, side surface of the intermediate layer 12, side surface of the oxide superconducting layer 13, and side surface of the protection layer 14). Reference numeral 15c denotes a second main surface (surface opposite to the main surface 11a of the base material 11) of the superconducting laminate 15.

The stabilization layer 16 is formed to cover the superconducting laminate 15. The stabilization layer 16 covers a portion or all of the region selected from the surface (main surface 14a) of the protection layer 14, the side surface of the protection layer 14, the side surface of the oxide superconducting layer 13, the side surface of the intermediate layer 12, the side surface of the base material 11, and the back surface of the base material 11 (surface opposite to the main surface 11a of the base material 11). The thickness of the stabilization layer 16 is not particularly limited, and may be, for example, approximately 10 to 300 µm.

The stabilization layer 16 has a function as a bypass portion that diverts an overcurrent generated when the oxide superconducting layer 13 is transferred to the normal conduction state. Examples of the constituent material of the stabilization layer 16 include metals such as copper, copper alloy, aluminum, aluminum alloy and silver.

When the oxide superconducting wire 10 is used for a superconducting current limiting device, it is necessary to instantaneously suppress the overcurrent generated at the transition to the normal conduction state. Therefore, a high-resistance metal may be used for the stabilization layer 16. Examples of high-resistance metals include Ni-based alloys such as Ni-Cr.

The stabilization layer 16 improves the electrical connection between the oxide superconducting layer 13 and the stabilization layer 16. Since the stabilization layer 16 covers the side surface of the oxide superconducting layer 13, the peeling prevention property and the waterproofness of the oxide superconducting layer 13 are improved. The portion of the stabilization layer 16 covering the first main surface 15a of the superconducting laminate 15 is referred to as a first main surface portion 16A. The portion of the stabilization layer 16 covering the side surface 15b of the superconducting laminate 15 is referred to as a side surface portion 16B. The portion of the stabilization layer 16 covering the second main surface 15c of the superconducting laminate 15 is referred to as a second main surface portion 16C.

Fig. 2 is a view schematically showing a cross-section of the oxide superconducting wire 10. As shown in Fig. 2, F1 and F2 are residual stresses inside the stabilization layer 16. In particular, F1 is a residual stress of the first main surface portion 16A and the second main surface portion 16C. F2 is a residual stress of the side surface portion 16B.

The residual stresses F1 and F2 are stresses in the tensile direction (tensile stress). That is, the residual stress F1 is a tensile stress in the direction in which the widths (dimensions in the X direction) in the first main surface portion 16A and the second main surface portion 16C expand. The residual stress F2 is a tensile stress in the direction in which the thickness dimension (dimension in the Y direction) increases in the side surface portion 16B. In the superconducting laminate 15, as shown by the broken arrows in Fig. 2, repulsive forces in the opposite direction to the residual stresses F1 and F2 occur.

The residual stresses F1 and F2 are preferably 0.2 MPa or more.
In the superconducting coil, it is possible to relieve external stress by subjecting the surface of the wire to a mold release treatment or the like. However, it is not easy to avoid the peeling stress at the time of coil cooling as described above. On the other hand, the peeling stress can fully be relieved as residual stress F1, F2 is 0.2 MPa or more, and peeling can be prevented.

In the oxide superconducting wire 10, both of the residual stresses F1 and F2 are tensile stresses. However, at least the residual stress F2 may be a tensile stress.

It is preferable that at least a portion of the stabilization layer 16 be a plating layer formed by plating on the outer peripheral surface of the superconducting laminate 15. When the stabilization layer 16 is a plating layer, adjustment of the residual stresses F1 and F2 is facilitated.

The stabilization layer 16 can be formed by electrolytic plating. At least a portion of the stabilization layer 16 may be formed by a method of forming a metal film by electrolytic plating on the metal film formed by sputtering or electroless plating.

In order to form the stabilization layer 16 by electrolytic plating, for example, the following method is possible. The superconducting laminate 15 is immersed in a plating bath, and the stabilization layer 16 is formed on the outer peripheral surface of the superconducting laminate 15 by electrolytic plating while the superconducting laminate 15 is pulled up. At this time, the residual stresses F1 and F2 of the stabilization layer 16 can be adjusted by adjusting such as (i) types and concentrations of additives to be added to the plating bath, (ii) temperature of the plating bath, (iii) pH of the plating bath, (iv) current density at plating, and (v) plating time. For example, in the case of copper (Cu) plating, the residual stress of the stabilization layer 16 tends to be compressive stress in an alkaline bath (such as a cyanide bath) and tensile stress in an acid bath (such as a copper sulfate bath).

The relationship between residual stress in a metal layer formed by plating and plating conditions is widely known in the field of surface technology. For example, it is described in such as Reference 1: Practical surface technology, Vol. 22 (1975) No. 2, "Introduction to easy plating theory (6)", and Reference 2: Surface technology Vol. 43, No. 7, 1992, "Internal stress of coating film formed by electroplating".

For measurement of the residual stresses F1 and F2 of the stabilization layer 16, known strip electrodeposition stress measurement methods can be used. The strip electrodeposition stress measurement method is described in the aforementioned Reference 2. For measurement of residual stress by a strip electrodeposition stress measurement method, for example, a strip type electrodeposition stress tester ("683 EC analyzer" manufactured by Fuji Kasei Co., Ltd.) can be used.

As a method of measuring the residual stresses F1 and F2 of the stabilization layer 16, a spiral contract meter method, an X-ray diffraction method or the like can also be adopted.

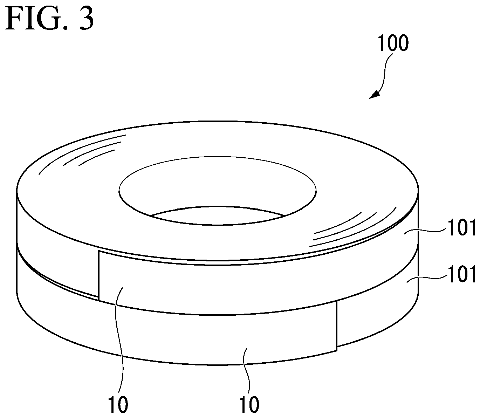

Fig. 3 is a view showing a superconducting coil 100 which is an example of a superconducting coil provided with the oxide superconducting wire of the present embodiment.

The superconducting coil 100 is configured by laminating a plurality of coil bodies 101. The coil body 101 is a pancake coil, and the oxide superconducting wire 10 shown in Fig. 1 is stacked and wound in the thickness direction. The pancake coil is a coil formed by winding a tape-shaped oxide superconducting wire in an overlapping manner. The coil body 101 of the superconducting coil 100 shown in Fig. 3 is annular. The coil body 101 is covered with an impregnated resin layer (not shown). The impregnated resin layer is made of epoxy resin, phenol resin or the like. The plurality of coil bodies 101 may be electrically connected to each other. The superconducting coil 100 can be used for a superconducting device (not shown).

In the superconducting coil 100, the residual stress F2 of the stabilization layer 16 is preferably larger than the maximum applied stress in the radial direction of the coil. According to the present configuration, the repulsive force in the direction opposite to the residual stress F2 relieves the peeling stress of the superconducting laminate 15, and damage such as peeling of the oxide superconducting layer 13 and the like can be avoided. Therefore, the deterioration due to the damage can be prevented.

The maximum applied stress in the radial direction of the coil can be set by adjusting the ratio of the inner diameter to the outer diameter of the superconducting coil. The relationship between the ratio of the inner diameter to the outer diameter of the coil and the applied stress in the coil radial direction is described in, for example, the following References i) to iii).
i) Generalized plane strain analysis of superconducting conducted solenoids, JOURNAL OF APPLIED PHYSICS vol. 86, number 12
ii) Degradation-Free Impregnated YBCO Pancake Coils by Decreasing Radial Stress in the Windings and Method for Evaluating Delamination Strength of YBCO-Coated Conductors, IEEE TRANSACTIONS ON APPLIED SUPERCONDUCTIVITY, VOL. 24, NO. 3, JUNE 2014
iii) Delamination Strengths of Different Types of REBCO-Coated Conductors and Method for Reducing Radial Thermal Stresses of Impregnated REBCO Pancake Coils, DOI 10.1109/TASC.2014.2372048, IEEE Transactions on Applied Superconductivity

In order to produce the superconducting coil 100, a method of fixing the oxide superconducting wire 10 can be adopted such that after forming a multilayer wound coil by winding the oxide superconducting wire 10 around a winding frame to have the necessary number of layers, and then a resin such as epoxy resin is impregnated so as to cover the wound oxide superconducting wire 10.

In the oxide superconducting wire 10, the residual stresses F1 and F2 inside the stabilization layer 16 are tensile stresses. In addition, the residual stress F2 is larger than the maximum applied stress in the radial direction of the superconducting coil.

In the case of a superconducting coil in which an oxide superconducting wire is wound into a coil and impregnated with a resin such as an epoxy resin, for example, in the case of cooling, due to the difference in thermal expansion coefficient between the oxide superconducting wire and the resin. Stress in the direction in which the layers of the superconducting laminate peel (peeling stress) may act. In addition, in the oxide superconducting wire, a portion of the layer in the edge portion (side surface portion) may be damaged by such as peeling due to the contact with the flange of the winding frame, the flange of the delivery (or take-up) reel, or the like in the coil manufacturing process.

In the oxide superconducting wire 10 of the present embodiment, since the residual stresses F1 and F2 in the inside of the stabilization layer 16 are tensile stress, in the superconducting laminate 15, repulsive force in the opposite direction to the residual stresses F1 and F2 is generated as shown by the broken arrows in Fig. 2. Therefore, for example, the peeling stress of the superconducting laminate 15 is relieved, and damage such as peeling of the oxide superconducting layer 13 and the like can be avoided. Further, in the superconducting coil 100 of the present embodiment, the residual stress F2 is larger than the maximum applied stress in the radial direction of the superconducting coil. Therefore, the repulsive force in the direction opposite to the residual stress F2 relieves the peeling stress of the superconducting laminate 15 and damage such as peeling of the oxide superconducting layer 13 or the like can be avoided.

Therefore, deterioration due to the damage can be prevented.

In particular, when the residual stress F2 in the side surface portion 16B of the stabilization layer 16 is a tensile stress along the thickness direction of the superconducting laminate 15, peeling can be reliably prevented by the repulsive force against the force in the peeling direction.

### EXAMPLES

Hereinafter, test results of the superconducting coil configured by using the oxide superconducting wire 10 shown in Fig. 1 is described. The present invention is not limited to the examples shown below.

### Test Examples 1 to 4

A tape-like base material having a width of 12 mm, a length of 300 m, and a thickness of 75 µm made of HASTELLOY® C-276 (trade name) manufactured by Haynes International, USA was prepared. The surface of the base material was polished using an abrasive (average particle diameter: 3 µm) made of alumina, and then degreased and washed with an organic solvent (ethanol or acetone).

An intermediate layer was formed on the main surface of the base material as follows. The intermediate layer has a configuration in which a diffusion prevention layer, a bed layer, an orientation layer and a cap layer are laminated in this order.

A diffusion prevention layer of Al₂O₃ with 100 nm-thick was formed on the base material by the ion-beam sputtering method. Then, a bed layer of Y₂O₃ with 30 nm-thick was formed on the diffusion prevention layer by the ion beam sputtering method. Next, an orientation layer of MgO with 5-10 nm-thick was formed on the bed layer by the IBAD method. Next, on the orientation layer, a cap layer of CeO₂ with 500 nm-thick was formed by the pulsed laser deposition (PLD) method.

On the cap layer, an oxide superconducting layer of GdBa₂Cu₃O_{7-X} with 2 µm-thick was formed by the PLD method.

Next, on the oxide superconducting layer, a protection layer of Ag with 2 µm-thick was formed by the DC sputtering method to obtain a superconducting laminate (raw material, with a width of 12 mm).

The superconducting laminate (raw material) was subjected to the oxygen annealing treatment (500 °C, 10 hours) in an oxygen atmosphere in a heating furnace, the furnace cooling for 26 hours, and then taken out from the heating furnace.

The superconducting laminate (raw material) was divided into three superconducting laminates (with a width of 4 mm).

A copper film (1 µm-thick film on the back surface of the base material and 0.3 µm-thick film on the side surface of the superconducting laminate) is formed on the outer peripheral surface (back of the base material and the side surface of the superconducting laminate) of the superconducting laminate by the DC sputtering method.

The superconducting laminate having a length of 300 m was cut at the center in the longitudinal direction to obtain a superconducting laminate having a length of 150 m.

A stabilization layer of Cu having a thickness of 20 µm was formed by electrolytic plating on the outer peripheral surfaces of the plurality of superconducting laminates to obtain an oxide superconducting wire. Table 1 shows the plating conditions (materials of the stabilization layer and plating bath) when forming the stabilization layer.

The oxide superconducting wire was wound around a winding frame with an inner diameter of 30 mm to produce a coil body. The coil body was vacuum impregnated with epoxy resin to obtain a superconducting coil.

Ten superconducting coils different in maximum applied stress in a radial direction of the coil were made for each of Test Examples 1 to 4, and the number of the deteriorated superconducting coils was recorded.

The determination of deterioration was based on the result of n values (in the range of 10⁻⁵ to 100⁻⁶ V/cm) measured in liquid nitrogen. The n value is a multiplier when the approximate curve of the I-V characteristic is represented by a power multiplier, and is an indicator to determine that a voltage is locally generated from the wire inside the coil (i.e., the oxide superconducting wire is deteriorated) when the n value changes. When the measured n value was 20 or less, it was determined that the oxide superconducting wire was deteriorated.

The maximum applied stress in the radial direction of the coil was set by adjusting the ratio of the inner diameter to the outer diameter of the superconducting coil. The residual stress of the stabilization layer (residual stresses F1 and F2 shown in Fig. 2) was measured. The residual stress was measured by a strip electrodeposition stress measurement method using the above-mentioned strip type electrodeposition stress tester manufactured by Fuji Kasei Co., Ltd.

"Compression" in Table 1 means compressive stress and "tensile" means tensile stress. Regarding the residual stress, the compressive stress is expressed as a negative number, and the tensile stress is expressed as a positive number.

**(Table 1)**

| Test Example | Stabilization layer | Plating bath | Residual stress (MPa) | Compression/ Tensile | Maximum applied stress in radial direction of coil | The number of deteriorated coil |
|---|---|---|---|---|---|---|
| 1 | Cu | cyanide bath | -10 | Compression | 0.21 | 6 |
| | | | | | 1.85 | 9 |
| | | | | | 6.9 | 9 |
| 2 | Cu | copper sulfate bath | 0.25 | Tensile | 0.21 | 0 |
| | | | | | 1.85 | 9 |
| | | | | | 6.9 | 9 |
| 3 | Cu | copper sulfate bath | 2 | Tensile | 0.21 | 0 |
| | | | | | 1.85 | 0 |
| | | | | | 6.9 | 9 |
| 4 | Cu | copper sulfate bath | 73 | Tensile | 0.21 | 0 |
| | | | | | 1.85 | 0 |
| | | | | | 6.9 | 0 |

As shown in Table 1, in Test Examples 2 to 4 in which the residual stress of the stabilization layer is a tensile stress, it is confirmed that deterioration of the coil did not occur, unlike Test Example 1 in which the residual stress is a compressive stress.

In addition, in the test example in which the residual stress of the stabilization layer (residual stress F2 shown in Fig. 2) is a tensile stress and the residual stress is larger than the maximum applied stress in the radial direction of the superconducting coil, it is confirmed that deterioration of the coil did not occur.

Although the present invention has been described above based on the preferred embodiments, the present invention is not limited to the above-described embodiments, and various modifications can be made without departing from the scope of the present invention.

In the oxide superconducting wire 10 shown in Fig. 2, both the residual stress F1 and the residual stress F2 are a tensile stress, but only the residual stress F2 may be a tensile stress.

The stabilization layer may be formed by a method other than plating (for example, sputtering), but is preferably formed by plating.

Although the stabilization layer preferably covers all the surfaces (the first main surface, the side surfaces, and the second main surface) of the superconducting laminate, the stabilization layer may cover at least the side surfaces of the superconducting laminate.

For example, the stabilization layer may be configured to cover the first main surface and the both side surfaces of the superconducting laminate.

### DESCRIPTION OF REFERENCE NUMERALS

10: Oxide superconducting wire material
11: Base material
12: Intermediate layer
13: Oxide superconducting layer
14: Protection layer
15: Superconducting laminate
16: Stabilization layer
16B: Side portion
F1, F2: Residual stress

## Claims

1. A superconducting wire comprising:
a superconducting laminate in which a superconducting layer formed on a base material with a tape shape via an intermediate layer; and
a stabilization layer covering at least a portion of the superconducting laminate, wherein a residual stress inside the stabilization layer is a tensile stress.

2. The superconducting wire according to claim 1, wherein a residual stress in a side surface portion of the stabilization layer covering a side surface of the superconducting laminate is a tensile stress along a thickness direction of the superconducting laminate.

3. The superconducting wire according to claim 1 or 2, wherein the residual stress is 0.2 MPa or more.

4. The superconducting wire according to any one of claims 1 to 3, wherein the stabilization layer is a plating layer.

5. A superconducting coil comprising the superconducting wire according to any one of claims 1 to 4, wherein:
the superconducting wire is laminated in a thickness direction of the superconducting coil;
the residual stress inside a side surface portion of the stabilization layer covering a side surface of the superconducting laminate is a tensile stress along a thickness direction of the superconducting laminate; and
the residual stress is larger than a maximum applied stress in a radial direction of the superconducting coil.
